# FASCICULE DE BREVET EUROPEEN

(11) **EP 2 529 418 B1**
(45) Date de publication et mention de la délivrance du brevet: **26.06.2019**
(21) Numéro de dépôt: 11708520.9
(22) Date de dépôt: 26.01.2011
(51) Int. Cl.: H01L 31/20, H01L 31/0236, H01L 21/306, H01L 31/075

(54) **PROCEDE DE REALISATION D'UNE CELLULE PHOTOVOLTAIQUE AVEC PREPARATION DE SURFACE D'UN SUBSTRAT EN SILICIUM CRISTALLIN**
VERFAHREN ZUR HERSTELLUNG EINER PHOTOVOLTAISCHEN ZELLE EINSCHLIESSLICH DER HERSTELLUNG DER OBERFLÄCHE EINES KRISTALLINEN SILICIUMSUBSTRATS
METHOD FOR PRODUCING A PHOTOVOLTAIC CELL INCLUDING THE PREPARATION OF THE SURFACE OF A CRYSTALLINE SILICON SUBSTRATE

(30) Priorité: 27.01.2010 FR 1000306
(43) Date de publication de la demande: 05.12.2012
(73) Titulaire: Commissariat à l'Énergie Atomique et aux Énergies Alternatives, 75015 Paris (FR)
(72) Inventeur: MORICEAU, Hubert, 38120 Saint-Egrève (FR); MUR, Pierre, 38920 Crolles (FR); RIBEYRON, Pierre-Jean, F-38330 Saint Ismier (FR)
(74) Mandataire: Talbot, Alexandre
(86) Numéro de dépôt international: PCT/FR2011/000049
(87) Numéro de publication internationale: WO 2011/092401

(56) Documents cités:
- WO-A2-2009/094578
- WO-A2-2009/120631
- JP-A- H0 621 214
- JP-A- 2007 194 485
- US-A1- 2002 104 822
- US-A1- 2009 215 218
- US-B1- 6 624 049
- CUI ZHENJIANG ET AL: "Rapid thermal oxidation of silicon in ozone", JOURNAL OF APPLIED PHYSICS, AMERICAN INSTITUTE OF PHYSICS. NEW YORK, US, vol. 87, no. 11, 1 juin 2000 (2000-06-01), pages 8181-8186, XP012049219, ISSN: 0021-8979, DOI: DOI:10.1063/1.373515
- KIM K ET AL: "OXIDE GROWTH ON SILICON (100) IN THE PLASMA PHASE OF DRY OXYGEN USING AN ELECTRON CYCLOTRON RESONANCE SOURCE", JOURNAL OF VACUUM SCIENCE AND TECHNOLOGY: PART B, AVS / AIP, MELVILLE, NEW YORK, NY, US, vol. 14, no. 4, 1 juillet 1996 (1996-07-01), pages 2667-2673, XP000622160, ISSN: 1071-1023, DOI: DOI:10.1116/1.589002
- MIKI N ET AL: "Selective etching of native oxide by dry processing using ultra clean anhydrous hydrogen fluoride", 19881211; 19881211 - 19881214, 11 décembre 1988 (1988-12-11), pages 730-733, XP010070755,
- PENA O ET AL: "Hydrogen plasma etching of silicon dioxide in a hollow cathode system", THIN SOLID FILMS, ELSEVIER-SEQUOIA S.A. LAUSANNE, CH, vol. 518, no. 12, 4 septembre 2009 (2009-09-04), pages 3156-3159, XP026946835, ISSN: 0040-6090, DOI: DOI:10.1016/J.TSF.2009.08.042 [extrait le 2009-09-04]
- EDWARDS M ET AL: "Effect of texturing and surface preparation on lifetime and cell performance in heterojunction silicon solar cells", SOLAR ENERGY MATERIALS AND SOLAR CELLS, ELSEVIER SCIENCE PUBLISHERS, AMSTERDAM, NL, vol. 92, no. 11, 1 novembre 2008 (2008-11-01), pages 1373-1377, XP024522875, ISSN: 0927-0248, DOI: DOI:10.1016/J.SOLMAT.2008.05.011 [extrait le 2008-07-14]
- KERR M J ET AL: "Surface recombination velocity of phosphorus-diffused silicon solar cell emitters passivated with plasma enhanced chemical vapor deposited silicon nitride and thermal silicon oxide", JOURNAL OF APPLIED PHYSICS, AMERICAN INSTITUTE OF PHYSICS. NEW YORK, US, vol. 89, no. 7, 1 avril 2001 (2001-04-01), pages 3821-3826, XP012053210, ISSN: 0021-8979, DOI: DOI:10.1063/1.1350633
- FESQUET L ET AL: "Modification of textured silicon wafer surface morphology for fabrication of heterojunction solar cell with open circuit voltage over 700 mV", PHOTOVOLTAIC SPECIALISTS CONFERENCE (PVSC), 2009 34TH IEEE, IEEE, PISCATAWAY, NJ, USA, 7 juin 2009 (2009-06-07), pages 754-758, XP031626462, ISBN: 978-1-4244-2949-3
- SAKODA T ET AL: "ADDITIONAL PLASMA SURFACE TEXTURING FOR SINGLE-CRYSTALLINE SILICON SOLAR CELLS USING DIELECTRIC BARRIER DISCHARGE", JAPANESE JOURNAL OF APPLIED PHYSICS, JAPAN SOCIETY OF APPLIED PHYSICS, JP, vol. 44, no. 4A, 1 avril 2005 (2005-04-01) , XP001245797, ISSN: 0021-4922, DOI: DOI:10.1143/JJAP.44.1730

## Description

### Domaine technique de l'invention

L'invention concerne un procédé de réalisation d'au moins une cellule photovoltaïque selon la revendication 1 comprenant les étapes successives suivantes :
- gravure anisotrope d'une surface d'un substrat en silicium cristallin
- et traitement par gravure isotrope de ladite surface, ledit traitement comprenant la formation d'un oxyde de silicium et le retrait dudit oxyde de silicium.

### État de la technique

Une cellule photovoltaïque est formée d'un empilement multicouche permettant de convertir directement les photons reçus en un signal électrique.

Une telle cellule photovoltaïque peut, par exemple, être une cellule photovoltaïque à hétérojonction. L'hétérojonction est, en particulier, formée par un substrat en silicium cristallin présentant un type de dopage (n ou p) donné et par une couche en silicium amorphe présentant un type contraire à celui du substrat. De plus, une couche intermédiaire dite de « passivation » est, le plus souvent, disposée entre les deux éléments formant l'hétérojonction, afin d'améliorer les caractéristiques d'interface de l'hétérojonction et donc l'efficacité de la conversion. Comme indiqué dans la demande de brevet US2001/0029978, cette couche intermédiaire est, en général, une couche en silicium amorphe intrinsèque.

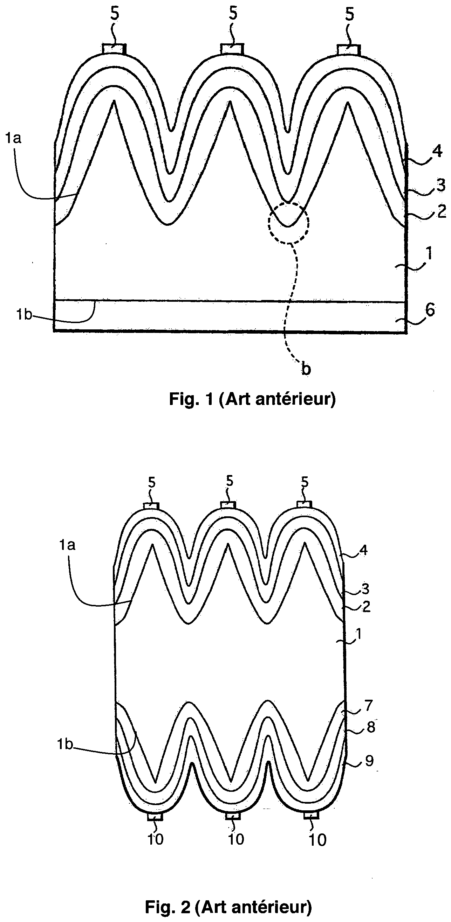

À titre d'exemple, la figure 1 illustre un mode particulier de réalisation d'une cellule photovoltaïque à hétérojonction selon l'art antérieur, telle que décrite dans la demande de brevet US2001/0029978. La cellule photovoltaïque à hétérojonction comporte un substrat en silicium cristallin 1, par exemple dopé de type n et comprenant une face avant 1a, recouverte uniformément et successivement par :
- une couche en silicium amorphe intrinsèque 2,
- une couche en silicium amorphe 3, dopé par exemple de type p pour former l'hétérojonction avec le substrat 1,
- une électrode 4, par exemple en oxyde d'indium et d'étain (ou ITO)
- et un collecteur de courant 5, par exemple sous la forme d'un peigne.

La face avant 1a du substrat 1 est, de plus, texturée (ou structurée), afin d'augmenter le confinement optique de la cellule.

La face arrière 1b du substrat 1 est, sur la figure 1, plane et recouverte d'une électrode 6. Elle peut, cependant, dans d'autres cas, être texturée et recouverte d'un empilement multicouche comme représenté sur la figure 2. Ainsi, dans ce mode de réalisation, la face arrière 1b du substrat 1 est recouverte uniformément et successivement par :
- une couche en silicium amorphe intrinsèque 7,
- une couche en silicium amorphe 8, très fortement dopée, par exemple, de type n,
- une électrode 9, en ITO par exemple
- et un collecteur de courant 10 sous la forme d'un peigne.

Ainsi, les cellules photovoltaïques, telles que les cellules photovoltaïques à hétérojonction comme illustré sur les figures 1 et 2, nécessitent de déposer, de manière uniforme, une pluralité de couches très fines (de l'ordre de quelques nanomètres à quelques dizaines de nanomètres) sur un substrat dont au moins une face est texturée. Par dépôt uniforme, également appelé dépôt conforme par certains, d'une couche mince, on entend le dépôt d'une couche mince d'une épaisseur sensiblement constante, afin de suivre le relief de la face sur laquelle la couche mince est déposée.

Or, l'étape de texturation du substrat d'au moins une face ne facilite pas la bonne conformation (ou répartition uniforme) de ces couches.

De plus, dans le domaine des cellules photovoltaïques, il est courant de texturer au moins une face du substrat sous la forme de pyramides comme représenté sur les figures 1 et 2. Or, les flancs des pyramides obtenues sont souvent très rugueux et les pointes et les creux des pyramides sont abruptes (rayon de courbure < 30 nm), ce qui est néfaste pour obtenir une parfaite conformation des couches déposées successivement sur la face texturée.

En général, la texturation est, avantageusement, réalisée par au moins une étape de gravure anisotrope à l'aide d'une solution alcaline, telle que de l'hydroxyde de potassium (KOH) ou de l'hydroxyde de sodium (NaOH). Il a aussi été proposé d'ajouter un agent actif d'interface, tel que l'alcool isopropylique (IPA) à la solution alcaline, afin de limiter le phénomène de rugosité.

À titre d'exemple, dans la demande de brevet US2001/0029978, le substrat 1 est texturé en réalisant un nettoyage de la surface puis en plongeant le substrat nettoyé dans une solution alcaline, telle que NaOH à laquelle est éventuellement ajouté de l'alcool isopropylique (IPA) afin de réaliser la gravure anisotrope.

Pour éviter certains problèmes liés à la gravure anisotrope, la demande de brevet US2001/0029978 propose aussi de faire suivre l'étape de gravure anisotrope par une étape destinée à arrondir les zones disposées entre deux pyramides (zones « b » sur la figure 1) formées lors de l'étape de gravure anisotrope. Pour cela, le substrat subit une série d'étapes de nettoyage, avant d'être soumis à une étape de gravure isotrope, par immersion dans une solution aqueuse contenant de l'acide fluorhydrique (HF) et de l'acide nitrique (HNO₃), dans un rapport 1 :20, pendant environ 30 secondes. Ensuite, le substrat subit des étapes de nettoyage (eau déionisée également notée eau DI, puis HF+eau, puis eau DI). Ainsi, l'étape de gravure isotrope avec le mélange d'HF et d'HNO₃ permet, de manière connue, de former un oxyde de silicium grâce à l'action oxydante de l'acide nitrique et d'éliminer par gravure ledit oxyde de silicium grâce à l'action d'attaque de l'acide fluorhydrique. Selon une alternative mentionnée dans la demande de brevet US2001/0029978, le mélange aqueux peut aussi contenir CH₃COOH.

La gravure isotrope par voie humide proposée dans la demande de brevet US2001/0029978 est, cependant, trop importante (de l'ordre de 2 µm ou plus). Elle ne permet donc pas d'obtenir un lissage des flancs des pyramides au niveau nanométrique, ni même d'arrondir les sommets des pyramides.

Dans la demande de brevet US2001/0029978, il est aussi proposé de remplacer la gravure isotrope humide avec HF et HNO₃ par une gravure sèche utilisant le couple gazeux CF₃/O₂. Cependant, une telle opération de gravure endommage l'état de surface ainsi traité en créant une perturbation cristalline en surface, voire en subsurface, ce qui peut provoquer des problèmes de passivation.

Dans la demande de brevet WO-A- 2009/120631, la réalisation de cellules photovoltaïques comprend une étape de texturation de surface pour former des motifs en forme de pyramides par exemple. De plus, le procédé décrit dans la demande de brevet WO-A- 2009/120631 peut aussi comporter une étape de post-nettoyage réalisée par une opération d'oxydation de la surface, suivie d'une opération de gravure. L'opération d'oxydation est réalisée par voie chimique, par immersion dans une solution liquide telle qu'un bain d'eau déionisée comprenant entre 1ppm et 30 ppm d'ozone, avec éventuellement 1%vol d'HCl. Cette opération d'oxydation par voie chimique génère alors un oxyde très fin, non homogène en épaisseur sur la surface texturée à traiter. Le retrait par gravure d'un tel oxyde est suffisant pour réaliser un nettoyage de surface, mais reste insuffisant pour obtenir un lissage de la texturation, dont le but est d'arrondir ou d'adoucir les angles de la texture. C'est pourquoi dans la demande de brevet WO-A-2009/12631, une étape spécifique de lissage est, en particulier, réalisée avant cette étape de post-nettoyage, lorsque l'on souhaite arrondir ou adoucir les angles de la texturation réalisée. Cette étape éventuelle de lissage est, comme dans la demande de brevet US2001/0029978, réalisée par voie humide, avec les inconvénients ci-dessus détaillés.

Par ailleurs, les documents US 2009/0215218 et US 6624049 divulguent des procédés de réalisation d'une cellule solaire à partir d'un substrat en silicium. Lesdits procédés comprennent notamment une étape de nettoyage de la surface du substrat, réalisée par le dépôt d'une couche d'oxyde thermique puis son retrait de la surface du substrat.

### Objet de l'invention

L'invention a pour but de proposer, pour un procédé de réalisation d'au moins une cellule photovoltaïque, un traitement par gravure isotrope permettant d'améliorer l'état de surface du substrat en silicium cristallin une fois ladite surface gravée de manière anisotrope, par rapport aux traitements par gravure isotrope proposés selon l'art antérieur. En particulier, le but de l'invention est d'obtenir, pour une surface d'un substrat texturée sous la forme de pyramides, un arrondissement des sommets et des zones disposées entre deux pyramides ainsi qu'un lissage des flancs desdites pyramides.

Selon l'invention, ce but est atteint par un procédé de réalisation d'au moins une cellule photovoltaïque comprenant les étapes successives suivantes :
- gravure anisotrope d'une surface d'un substrat en silicium cristallin
- et traitement par gravure isotrope de ladite surface, ledit traitement comprenant la formation d'un oxyde de silicium et le retrait dudit oxyde de silicium,
caractérisé en ce que le traitement par gravure isotrope de ladite surface comprend deux opérations successives, respectivement constituées par une oxydation par voie sèche activée thermiquement formant, à ladite surface du substrat, un film mince d'oxyde de silicium d'une épaisseur comprise entre 2nm et 500nm et par le retrait dudit film mince en oxyde de silicium.

Selon l'invention, les deux opérations successives constituent un cycle opérationnel répété au moins une fois pendant le traitement par gravure isotrope.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 et 2 représentent respectivement, schématiquement et en coupe, des premier et second modes de réalisation d'une cellule photovoltaïque selon l'art antérieur.
- les figures 3 à 9 illustrent différents étapes d'un procédé particulier de réalisation d'au moins une cellule photovoltaïque selon l'invention.
- les figures 10 à 15 illustrent des variantes de réalisation selon l'invention.

### Description de modes particuliers de réalisation

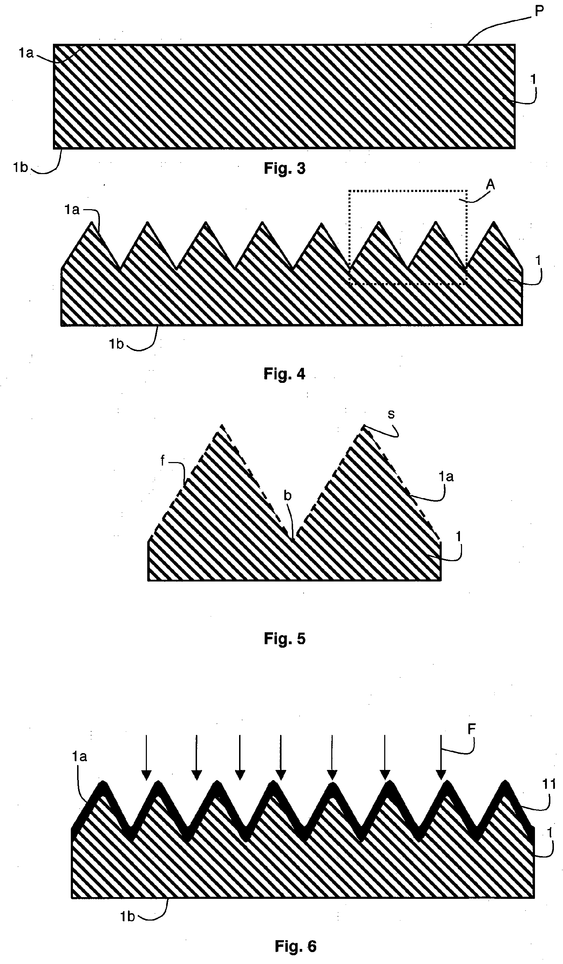

Les différentes étapes d'un mode particulier de réalisation d'au moins une cellule photovoltaïque telle qu'une cellule photovoltaïque à hétérojonction, sont illustrées sur les figures 3 à 9.

La face avant 1a sensiblement plane d'un substrat en silicium cristallin 1, par exemple dopé de type n, subit, en premier lieu, une opération de gravure anisotrope.

En particulier, sur les figures 3 et 4, la gravure anisotrope de la face avant 1a du substrat 1 permet de structurer (ou texturer) la face avant 1a sous la forme de pyramides. Elle est, par exemple, réalisée en immergeant la face 1a du substrat 1 dans une solution aqueuse de gravure anisotrope, contenant de l'hydroxyde de potassium (KOH) et de l'alcool isopropylique (IPA), pendant 30 minutes et à une température de 80°C. De plus, lorsque seule la face avant 1a du substrat 1 est structurée comme représenté sur les figures 3 et 4, la face arrière 1b peut être recouverte d'un masque de protection (par exemple en SiO₂ ou Si₃N₄), résistant à la gravure anisotrope réalisée avec la solution aqueuse contenant KOH afin de préservée ladite face arrière 1b.

Pour un substrat en silicium présentant un axe cristallographique (100) orienté perpendiculairement à sa surface, les flancs «f» des pyramides obtenues forment, en général, un angle de 54,7° avec le plan « P » principal de la face 1a, c'est-à-dire le plan de la face 1a avant que celle-ci ne soit texturée. De plus, les largeurs des pyramides sont comprises entre 0,1*µ*m et 40*µ*m et avantageusement entre 1*µ*m et 30*µ*m, selon la concentration de la solution aqueuse et le temps de gravure.

Comme illustré par l'agrandissement A d'une partie de la face avant 1a du substrat 1, l'état de surface de ladite face 1a après l'opération de gravure anisotrope et, en particulier, les flancs « f » des pyramides sont rugueux (schématisé par les traits en pointillés sur la figure 5) et les sommets « s » des pyramides, tout comme les zones « b » disposées entre deux pyramides, sont abrupts (avec, en particulier, un rayon de courbure inférieur à 30nm).

Pour améliorer l'état de surface de la face 1a après l'opération de gravure anisotrope et, en particulier, pour lisser les flancs « f » des pyramides avantageusement créées et pour arrondir les zones dites « b » disposées entre deux pyramides et les sommets « s » desdites pyramides, il est proposé de réaliser un traitement par gravure isotrope comprenant au moins deux opérations successives consistant respectivement à former un film mince en oxyde de silicium d'une épaisseur contrôlée et à retirer ledit film mince ainsi formé, de préférence de manière homogène. L'épaisseur du film mince en oxyde de silicium est, de plus, comprise entre 2nm et 500nm et elle est, préférentiellement, homogène sur au moins les flancs « f » des pyramides et avantageusement sur toute la surface traitée.

La formation d'un film mince en oxyde de silicium sur la face 1a du substrat 1 est réalisée par une opération d'oxydation par voie sèche activée thermiquement, c'est-à-dire en oxydant la face du substrat au moyen d'un agent oxydant non liquide tout en maintenant ladite face à une température supérieure à la température ambiante. L'agent oxydant peut, en particulier, être sous forme gazeuse ou bien être contenu dans un plasma. Il peut, par exemple, être de l'oxygène, de l'ozone, de l'eau, seuls ou en mélange. Plus particulièrement, l'activation thermique de l'oxydation par voie sèche consiste à fournir de l'énergie à la face du substrat, en appliquant un budget thermique défini par au moins une température supérieure à la température ambiante et avantageusement supérieure ou égale à 40°C. De plus, un tel budget thermique est, avantageusement, adapté pour permettre d'obtenir un compromis entre une montée en température rapide et suffisamment élevée pour générer le film mince en oxyde de silicium et l'obtention d'une température finale pas trop élevée pour éviter une altération des propriétés de surface ou de volume du substrat en silicium.

En effet, le fait de former un film mince en oxyde de silicium d'une épaisseur particulière et contrôlée, puis de le retirer permet :
- de diminuer fortement la rugosité de surface de la face texturée du substrat et donc d'assurer un niveau minimum de densité d'état à l'interface avec la couche mince destinée à être directement disposée sur ladite face du substrat,
- et d'arrondir les angles des structures (sommets « s » et zones « b » des pyramides), ce qui permet d'obtenir une meilleure conformation des couches minces déposées ultérieurement.

De plus, le traitement permet également d'éliminer une grande partie des contaminations particulaires, qui sont particulièrement critiques sur des substrats en silicium texturés.

Plus particulièrement, le traitement par gravure isotrope peut être réalisé de différentes manières.

En particulier, l'opération d'oxydation par voie sèche activée thermiquement peut être une oxydation thermique, c'est-à-dire une oxydation au moyen d'au moins un agent oxydant sous forme gazeuse ou contenu dans un plasma et par application à la face du substrat d'une température supérieure à la température ambiante et avantageusement supérieure ou égale à 40°C. En particulier, la température appliquée est inférieure à 1100°C. Une telle opération est, plus particulièrement, réalisée par un procédé de traitement rapide, également connu sous le nom anglo-saxon « Rapid Thermal Process » ou l'acronyme « RTP », afin d'obtenir une oxydation isotrope. Ainsi, l'opération d'oxydation par voie sèche est, de préférence, réalisée avec une montée en température très rapide (par exemple entre 100°C/s et 200°C/s). Par contre, la température finale obtenue à l'issue de cette montée en température est, de préférence, modérée afin d'éviter un endommagement de l'état de surface traité et des propriétés de volume du substrat.

L'opération d'oxydation par voie sèche activée thermiquement peut aussi être assistée ou bien elle peut être obtenue par application de rayonnements ultraviolets de longueurs d'onde situées une gamme de 0,15*µ*m à 0,4*µ*m et avantageusement d'environ 254nm et d'environ 185nm. De même, elle peut, aussi, être assistée ou bien obtenue par un traitement par plasma, activé par exemple en radiofréquence, en micro-ondes ou en hyperfréquence. Le plasma peut, par exemple, être un plasma, tel qu'un plasma inductif ou un plasma de gravure réactive ionique (RIE). L'agent oxydant peut être un gaz ou un mélange de gaz pouvant contenir de l'oxygène, de l'ozone, de la vapeur d'eau ou bien il peut être une autre espèce gazeuse oxydante, seule ou en combinaison, sous une forme moléculaire, ionique, radicalaire ou atomique. La pression totale lors de l'opération d'oxydation peut être de tout type : elle peut être atmosphérique, sub-atmosphérique ou sur-atmosphérique. Il est aussi possible de faire varier la ou les pressions partielles de chaque espèce constituant l'agent oxydant en fonction de la pression totale. En particulier, la ou les pressions partielles de chaque espèce pourront être ajustées en fonction de la vitesse d'oxydation souhaitée.

Selon un premier exemple, l'opération d'oxydation peut être une oxydation thermique réalisée avec une température de l'ordre de 400°C, avec un mélange gazeux d'oxygène et d'ozone (en particulier de 3 à 4% d'O₃ par rapport à O₂). Une telle opération permet d'obtenir un film mince en oxyde de silicium ayant une épaisseur suffisante pour améliorer l'état de surface, une fois ledit film retiré. On choisira, avantageusement, une épaisseur supérieure à 10 nm, qui peut être obtenue par exemple avec une température de 450°C pendant 3 heures. Des épaisseurs plus importantes peuvent être obtenues en augmentant la température et/ou le temps de traitement. Par exemple, on peut obtenir 25 nm d'oxyde de silicium avec une température de 550°C pendant 4 heures. On peut également, pour augmenter l'épaisseur d'oxyde de silicium généré pendant l'opération de traitement par gravure isotrope, réitérer un cycle opérationnel formé des opérations successives d'oxydation et de retrait, comme cela sera détaillé ultérieurement. L'épaisseur en oxyde de silicium est multipliée par quatre par rapport à un film obtenu par oxydation avec seulement de l'oxygène à la même température.

Selon un second exemple, l'opération d'oxydation peut être une oxydation thermique réalisée entre 700°C et 800°C, assistée par rayonnement UV dans un mélange gazeux d'oxygène et d'ozone (environ 2ppm d'O₃ par rapport à O₂). Une telle opération permet d'obtenir un film mince en oxyde de silicium ayant une épaisseur suffisante pour améliorer l'état de surface, une fois ledit film retiré. L'épaisseur en oxyde de silicium est augmentée de 50% à 100% par rapport à un film obtenu par oxydation avec seulement de l'oxygène. L'épaisseur d'oxyde de silicium généré sera, avantageusement choisie de manière à être supérieure à 10 nm. Par exemple, avec une oxydation à 800°C pendant 140mn, on obtient un film d'oxyde de silicium d'une épaisseur de l'ordre de 25nm. Pour la même durée, on obtient un film de 60nm d'épaisseur, à 900°C et de 5nm à 700°C. L'épaisseur d'oxyde de silicium généré pendant l'opération de traitement par gravure isotrope peut aussi être augmentée par un cycle opérationnel formé des opérations successives d'oxydation et de retrait, comme cela sera détaillé ultérieurement.

Selon un troisième exemple, l'opération d'oxydation peut être une oxydation obtenue par un traitement par plasma activé en micro-ondes (2,45GHz) et assisté par polarisation DC-magnétron (100V) et avec une pression partielle en oxygène d'environ 100mT. Dans ce cas, le film mince d'oxyde formé présente une épaisseur de l'ordre de 400nm pour une durée d'oxydation d'une heure, sur une surface d'une plaquette de silicium dont la température de surface est maintenue à environ 600°C.

L'opération de retrait du film mince d'oxyde de silicium, suivant directement l'opération d'oxydation, peut être effectuée par voie sèche, par exemple par gravure ionique réactive (RIE) ou bien par voie humide, par exemple en immergeant la face 1a du substrat 1 dans une solution liquide contenant de l'acide chlorhydrique (HCI) et de l'acide fluorhydrique (HF) éventuellement tamponné (BHF). L'opération de retrait peut aussi être réalisée par traitement en milieu réducteur, par exemple en réalisant un traitement thermique sous hydrogène. Ces exemple d'étapes de retrait sont connues pour être des étapes de retrait homogène, c'est-à-dire un retrait avec une vitesse de retrait constante sur sous la surface, malgré la texturation.

De plus, les deux opérations successives constituent un cycle opérationnel qui est répété au moins une fois. Une telle répétition est en particulier avantageuse lorsque le film mince en oxyde de silicium formé a une épaisseur de l'ordre de 2nm. La répétition des deux opérations successives d'oxydation et de retrait du film mince en oxyde de silicium permet d'optimiser le procédé et notamment d'obtenir un gain de temps.

Par ailleurs, dans ce mode de réalisation, l'épaisseur globale (ou cumulée) d'oxyde de silicium formé au cours du traitement par gravure isotrope est avantageusement supérieure à 10nm et, de préférence, supérieure à 20nm. Par épaisseur globale d'oxyde de silicium, on entend dans ce mode de réalisation, la somme des épaisseurs des films minces en oxyde de silicium successivement formés au cours du traitement, ce qui correspond, plus précisément, à l'épaisseur d'un film d'oxyde de silicium formé par la totalité des différentes opérations successives d'oxydation dans l'hypothèse où elles ne seraient pas entrecoupées par des opérations de retrait.

Dans un mode de réalisation ne faisant pas partie de l'invention, si le cycle opérationnel n'a pas besoin d'être répété, l'épaisseur du film mince d'oxyde de silicium formé pendant l'unique opération d'oxydation par voie sèche activée thermiquement du traitement est, aussi, de manière avantageuse, supérieure à 10nm et, de préférence, supérieure à 20nm. On parlera, par analogie, aussi dans ce cas, d'épaisseur globale d'oxyde de silicium formé pendant le traitement par gravure isotrope.

La réalisation d'un ou plusieurs cycles opérationnel entraîne une très faible gravure du silicium, en lissant les flancs des pyramides et en modifiant non seulement la géométrie des sommets des pyramides mais aussi celle des zones disposées entre les pyramides, tout en maintenant le confinement optique de la texturation à un très bon niveau.

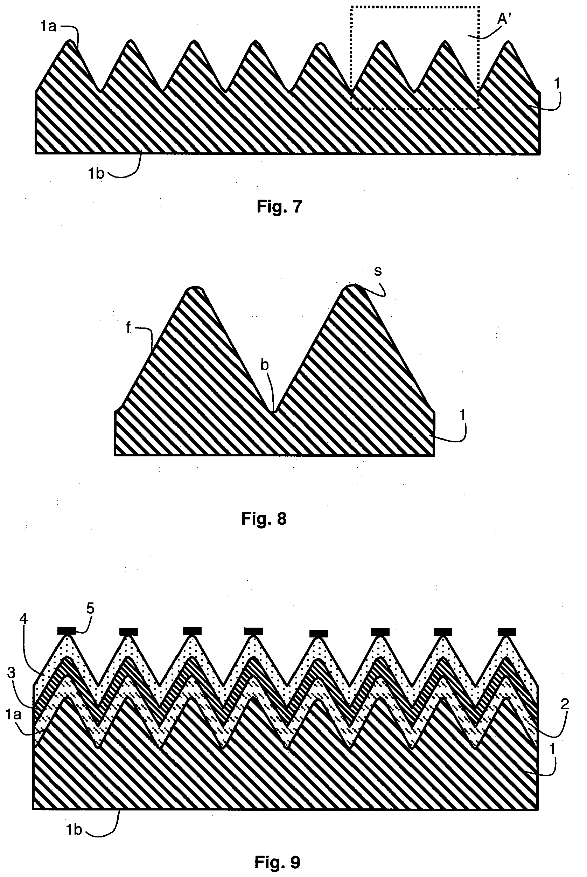

Le traitement par gravure isotrope de la face 1a du substrat 1 est, par exemple, illustré sur les figures 6 à 8. Les flèches F sur la figure 6 représentent l'opération d'oxydation par voie sèche activée thermiquement formant le film mince 11 en oxyde de silicium, sur la face 1a du substrat 1 et permettant l'arrondissement des sommets « s » des pyramides et des zones en creux « b » disposées entre les pyramides. Une fois l'opération réalisée, le film mince en oxyde de silicium 11 est retiré (figure 7). L'agrandissement A' représenté sur la figure 8 illustre un tel arrondissement pour les sommets « s » des pyramides et les zones en creux « b » disposées entre les pyramides ainsi que le lissage des flancs « f » (traits pleins sur la figure 8), une fois le film mince 11 retiré.

Puis, comme illustré sur la figure 9, l'opération de gravure isotrope peut être suivie de la formation, sur ladite surface, d'un empilement multicouche comprenant successivement :
- une couche mince en silicium amorphe intrinsèque 2 constituant, sur la figure 9, une couche de passivation,
- une couche mince en silicium amorphe 3 présentant un type de dopage opposé au type de dopage du substrat en silicium cristallin,
- une électrode 4
- et un collecteur de courant 5.

De plus, la face avant 1a du substrat 1 en silicium cristallin peut subir, après le traitement par gravure isotrope et avant la formation de l'empilement multicouche, au moins une étape de nettoyage et une étape de séchage. Ainsi, à titre d'exemple, la face 1a du substrat 1 peut subir un traitement avec un mélange d'acide fluorhydrique et d'acide chlorhydrique (HF/HCl), avec une faible teneur en HF, afin d'éviter une nouvelle contamination de la surface. Le traitement de nettoyage peut aussi être réalisé avec des vapeurs d'acide fluorhydrique (HF), suivi d'un rinçage avec un mélange d'eau désaérée sans oxygène libre et d'HCI pour éviter toute pollution de la surface par de l'oxygène. Cette pollution entraînerait la formation prématurée d'un oxyde natif, néfaste pour la réalisation de bonnes passivations de surface. De plus, une opération de séchage peut suivre, pour éviter tout dépôt contaminant sur les pyramides. Elle est, par exemple, réalisée avec de l'alcool isopropylique (IPA) vaporisé ou dans un liquide à faible tension de surface ou bien par immersion dans une solution liquide telle que de l'eau désaérée suivie d'une immersion dans une solution d'IPA de préférence chauffée. Avantageusement, la formation de l'empilement multicouche, par exemple par dépôt chimique en phase vapeur assisté par plasma (PECVD) peut alors être réalisée jusqu'à une demi-heure après le séchage, sans diminution du rendement des cellules photovoltaïques obtenues.

Comme dans les modes de réalisation représentés sur les figures 1 et 2, la face arrière 1b du substrat 1 peut, avantageusement, être recouverte par au moins une couche mince. Elle peut, par exemple, être recouverte par une électrode 6 telle que celle représentée sur la figure 1 ou bien par un empilement multicouche tel que celui représenté sur la figure 2.

De plus, l'invention n'est pas limitée aux modes de réalisation décrits ci-dessus, en particulier en ce qui concerne le type de dopage du substrat 1 et des couches en silicium amorphe 3 et 8. Par conséquent, l'invention n'est pas limitée aux modes de réalisation comprenant un substrat en silicium cristallin dopé n et des couches en silicium amorphe 3 et 8, respectivement dopées p et n. La couche en silicium amorphe 3 présente un type de dopage contraire à celui du substrat 1, afin de former l'hétérojonction de la cellule photovoltaïque et la couche en silicium amorphe 8 disposée du côté de la face arrière 1b du substrat 1 présente, en particulier, un type de dopage identique à celui du substrat 1. Par ailleurs, au lieu d'être en silicium amorphe, les couches minces 3 et 8 peuvent aussi être en silicium microcristallin.

De même, les modes de réalisation décrits ci-dessus illustrent une gravure anisotrope et un traitement par gravure isotrope de la face avant 1a du substrat 1. Cependant, ces gravures pourraient être envisagées non pas sur la face avant 1a du substrat 1, mais sur sa face arrière 1b ou même, en plus de la face avant 1a du substrat 1, sur la face arrière 1b du substrat 1. Dans ce cas, la couche mince en silicium amorphe ou microcristallin 8 de l'empilement multicouche disposé sur la face arrière 1b présente un type de dopage identique à celui du substrat en silicium cristallin 1.

Par ailleurs, selon une variante de réalisation, une étape de dépôt d'une couche d'un matériau d'une nature et/ou d'une structure cristalline et/ou d'une morphologie différente à celle du substrat 1 peut être réalisée entre l'étape de gravure anisotrope et le traitement par gravure isotrope. Une telle couche peut être formée par du silicium amorphe ou du silicium polycristallin ou bien par de l'oxyde de silicium ou par un oxyde à haute permittivité (High K) tel que l'HfO₂ ou Al₂O₃ ou ZrO₂. Elle peut, par exemple, être déposée par une technique de dépôt chimique en phase vapeur (CVD), à une température appropriée (par exemple de l'ordre de 100°C à 800°C).

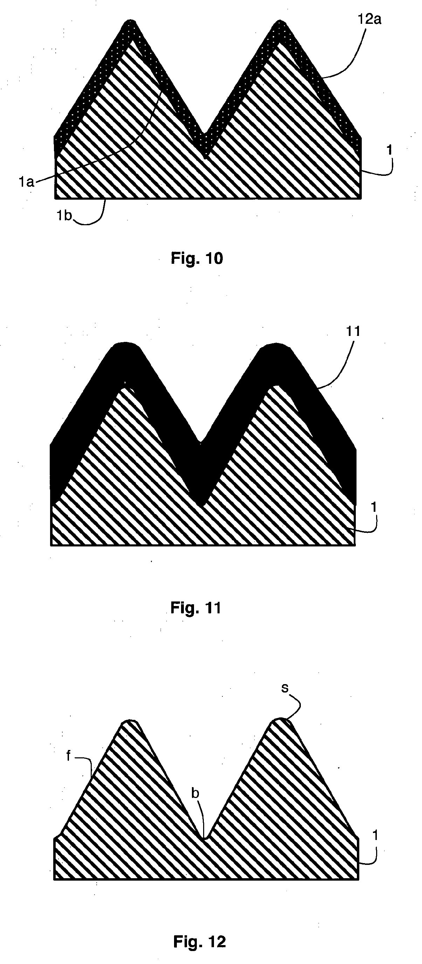

Ainsi, à titre d'exemple, sur les figures 10 à 12, une couche 12a formée par du silicium amorphe ou polycristallin est disposée sur la face avant 1a du substrat 1 entre l'étape de gravure anisotrope et le traitement par gravure isotrope. Dans ce cas, l'opération d'oxydation par voie sèche activée thermiquement permet d'oxyder le silicium de la couche 12a en même temps que la face du substrat 1a sur laquelle est disposée ladite couche 12, afin de former un film mince en oxyde de silicium 11.

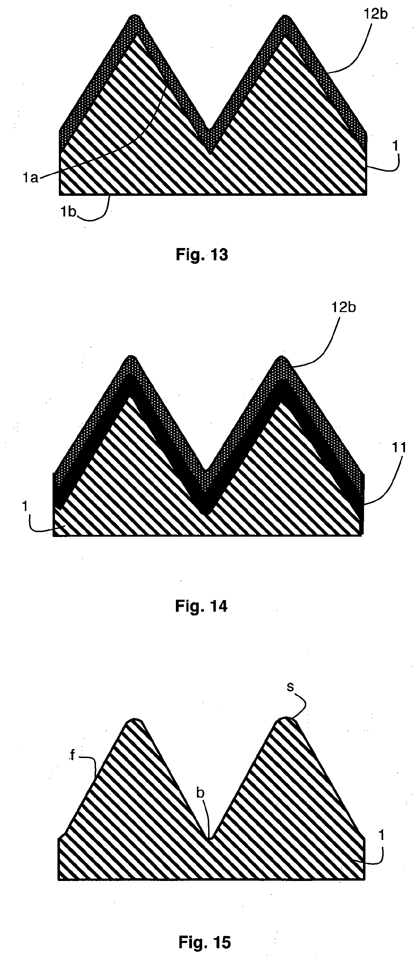

Sur les figures 13 à 15, une couche 12b formée par de l'oxyde de silicium est disposée sur la face avant 1a du substrat 1, une fois ladite face texturée. Dans ce cas, l'opération d'oxydation par voie sèche activée thermiquement permet d'oxyder, au travers de la couche 12b, la face avant du substrat 1, afin de former entre le substrat 1 et la couche 12b, un film mince en oxyde de silicium 11.

Dans tous les cas et comme illustré sur les figures 12 et 15, la couche 12a ou 12b est retirée lors de l'opération de retrait du film mince 11 en oxyde de silicium. De plus, cette couche 12a ou 12b doit être suffisamment épaisse, par exemple de l'ordre de la centaine de nanomètres. Elle est destinée à favoriser l'amélioration de l'état de surface de la surface traitée par gravure isotrope. En particulier, il se forme lors du dépôt de cette couche, un arrondissement au sommet « s » des pyramides et dans les zones « b » entre les pyramides. Ainsi, il est possible de différencier l'oxydation des flancs « f » de l'oxydation des zones « b » et des sommets « s » par rapport aux flancs « f » des pyramides, ce qui améliore le lissage des flancs « f » et l'arrondissement des zones « b » et des sommets « s ».

À titre d'exemple, un substrat présentant initialement un axe cristallographique <100> orienté perpendiculairement à sa surface est texturé afin de présenter, en surface, des pyramides ayant des sommets « s » et des creux « b » entre les pyramides ayant chacun une courbure présentant typiquement un rayon moyen de 30 nm. Il peut s'agir d'un substrat. Une couche 12a en silicium, d'une épaisseur de l'ordre de 100 nm est déposée par LPCVD sur ladite surface, dans une gamme de température de 500 à 620°C. Le silicium ainsi déposé est, alors, amorphe ou polycristallin. De plus, suivant le besoin, cette couche 12a peut être dopée. Il est à noter qu'après le dépôt de la couche 12a, les sommets « s » et les creux « b » formés par la couche 12a sont arrondies. Cet arrondissement permet d'obtenir un rayon de courbure de l'ordre de 200nm de rayon de courbure à l'aplomb des creux des pyramides. De plus, il est possible d'ajuster l'épaisseur de la couche 12a en fonction du rayon de courbure souhaité, selon les besoins de l'utilisateur. Cette couche est alors oxydée thermiquement pour en consommer toute son épaisseur par exemple par oxydation à 950°C sous vapeur d'eau (mode « steam »). Lors de l'oxydation, la présence de l'arrondi à la surface de la couche 12a en silicium induit alors un arrondi à la surface du substrat en silicium initial, au niveau des sommets et des creux des pyramides avec un rayon de courbure de l'ordre de 200 à 300 nm à l'aplomb des creux entre les pyramides. Après le retrait de l'oxyde, cette forme arrondie est conservée.

Selon une autre variante de réalisation, la couche de passivation formée par la couche mince en silicium amorphe intrinsèque 2 sur la figure 9 peut être au moins formée par une couche mince en oxyde cristallin de silicium disposée directement sur la surface du substrat préalablement traitée par gravure isotrope. Une telle couche mince en oxyde cristallin de silicium est, avantageusement, obtenue par oxydation superficielle radicalaire de la surface du substrat (1), par exemple au moyen de radicaux oxygénés obtenu à partir d'oxygène et/ou d'ozone et/ou d'eau. et elle n'est pas retirée. Elle a, avantageusement, une épaisseur inférieure ou égale à 2nm et elle peut être recouverte par de l'oxyde amorphe de silicium. À titre d'exemple, l'oxydation d'une partie superficielle du substrat 1 peut être réalisée à partir d'oxygène et de rayonnements ultraviolets ayant une gamme de longueurs d'onde comprise entre 160nm et 400nm. Les longueurs d'onde des rayonnements ultraviolets utilisés sont, par exemple, d'environ 185nm et d'environ 254nm. Dans ce mode particulier de réalisation, l'oxygène, sous l'action des rayonnements ultraviolets, se dissocie en radicaux libres O^{·} et en ozone et lesdits radicaux libres oxydent la surface du silicium et forment au moins la couche mince en oxyde cristallin de silicium.

De plus, dans une autre variante de réalisation, la couche de passivation peut être formée par la couche mince en oxyde cristallin de silicium et par la couche mince en silicium amorphe intrinsèque, cette dernière étant disposée entre la couche mince en oxyde cristallin de silicium et la couche mince en silicium amorphe ou microcristallin.

Enfin les modes de réalisation décrits ci-dessus concernent une cellule photovoltaïque à hétérojonction. Cependant, le traitement par gravure isotrope exposé dans ces différents modes de réalisation peut être appliqué à une surface d'un substrat en silicium cristallin ayant préalablement subi une étape de gravure anisotrope pour réaliser tout type de cellules photovoltaïques et plus particulièrement pour réaliser des cellules photovoltaïques à homojonction.

## Revendications

1. Procédé de réalisation d'au moins une cellule photovoltaïque comprenant les étapes successives suivantes :
- gravure anisotrope d'une surface (1a, 1b) d'un substrat (1) en silicium cristallin configurée pour structurer la face avant (1a) sous la forme de pyramides ;
- et traitement par gravure isotrope de ladite surface (1a, 1b), ledit traitement comprenant la formation d'un oxyde de silicium et le retrait dudit oxyde de silicium ;
**caractérisé en ce que** le traitement par gravure isotrope de ladite surface (1) comprend deux opérations successives, respectivement constituées par une oxydation par voie sèche activée thermiquement formant, à ladite surface (1a, 1b) du substrat (1), un film mince (11) d'oxyde de silicium d'une épaisseur comprise entre 2nm et 500nm et par le retrait dudit film mince (11) en oxyde de silicium ;
et **en ce que** les deux opérations successives constituent un cycle opérationnel répété au moins une fois pendant le traitement par gravure isotrope, de sorte à arrondir les sommets (s) des pyramides et les zones (b) disposées entre deux pyramides.

2. Procédé selon la revendication 1, **caractérisé en ce que** l'opération d'oxydation par voie sèche activée thermiquement comprend l'application à ladite surface (1a, 1b) du substrat (1) d'une température supérieure à la température ambiante et l'utilisation d'un agent oxydant sous une forme gazeuse ou contenu dans un plasma.

3. Procédé selon la revendication 2, **caractérisé en ce que** l'opération d'oxydation par voie sèche activée thermiquement comprend l'application d'un rayonnement ultraviolet sur ladite surface (1a, 1b) du substrat (1).

4. Procédé selon la revendication 2, **caractérisé en ce que** l'opération d'oxydation par voie sèche activée thermiquement comprend un traitement par plasma activé en micro-ondes, en radiofréquence ou en hyperfréquence.

5. Procédé selon l'une quelconque des revendications 1 à 4, **caractérisé en ce que** l'opération de retrait dudit film mince (11) en oxyde de silicium est effectuée par voie sèche.

6. Procédé selon l'une quelconque des revendications 1 à 4, **caractérisé en ce que** l'opération de retrait dudit film mince (11) en oxyde de silicium est effectuée par voie humide.

7. Procédé selon l'une quelconque des revendications 1 à 4, **caractérisé en ce que** l'opération de retrait dudit film mince (11) en oxyde de silicium est effectuée par traitement en milieu réducteur.

8. Procédé selon l'une quelconque des revendications 1 à 7, **caractérisé en ce que** l'oxyde de silicium formé au cours du traitement par gravure isotrope présente une épaisseur globale comprise entre 10nm et 500nm.

9. Procédé selon l'une quelconque des revendications 1 à 8, **caractérisé en ce que** la surface (1a, 1b) du substrat (1), une fois celle-ci traitée par gravure isotrope est recouverte au moins en partie d'un empilement multicouche comprenant successivement :
- une couche de passivation (2),
- une couche mince en silicium amorphe ou microcristallin (3, 8) présentant un type de dopage prédéterminé,
- une électrode (4)
- et un collecteur de courant (5).

10. Procédé selon la revendication 9, **caractérisé en ce que** le type de dopage de la couche mince en silicium amorphe ou microcristallin (3) est opoosé au type de dopage du substrat en silicium cristallin (1).

11. Procédé selon la revendication 9, **caractérisé en ce que** le type de dopage de la couche mince en silicium amorphe ou microcristallin (8) est identique au type de dopage du substrat en silicium cristallin (1).

12. Procédé selon l'une quelconque des revendications 9 à 11, **caractérisé en ce qu'**il comporte une étape de dépôt d'une couche (12a, 12b) formée avec un matériau d'une nature et/ou d'une structure cristalline et/ou d'une morphologie différente de celle du substrat (1), ladite étape étant réalisée entre la gravure anisotrope de la surface (1a, 1b) et le traitement par gravure isotrope et **en ce que** ladite couche est retirée pendant l'opération de retrait du film mince (11) d'oxyde de silicium.

13. Procédé selon l'une quelconque des revendications 9 à 12, **caractérisé en ce que** la couche de passivation (2) est formée par au moins une couche mince en silicium amorphe intrinsèque (2).

14. Procédé selon l'une quelconque des revendications 9 à 13, **caractérisée en ce que** la couche de passivation (2) est formée par au moins une couche mince en oxyde cristallin de silicium en contact direct avec ladite surface (1a, 1b) du substrat (1).

## Patentansprüche

1. Verfahren zur Herstellung mindestens einer Photovoltaikzelle, umfassend nacheinander die folgenden Schritte:
- anisotrope Gravur einer Oberfläche (1a, 1b) eines Substrats (1) aus kristallinem Silizium, die eingerichtet ist, um die Vorderseite (1a) in Form von Pyramiden zu strukturieren;
- und Bearbeitung der Oberfläche (1a, 1b) durch isotrope Gravur, wobei die Bearbeitung die Bildung eines Siliziumoxids und die Entfernung des Siliziumoxids umfasst;
**dadurch gekennzeichnet, dass** die Bearbeitung der Oberfläche (1) durch isotrope Gravur zwei aufeinanderfolgende Vorgänge umfasst, die von einer von einer thermisch aktivierten Trockenoxydation, die auf der Oberfläche (1a, 1b) des Substrats (1) eine dünne Siliziumoxidschicht (11) mit einer Dicke zwischen 2 nm und 500 nm bildet, bzw. von der Entfernung der dünnen Siliziumoxidschicht (11) gebildet sind;
und dass die zwei aufeinanderfolgenden Vorgänge einen Betriebszyklus darstellen, der mindestens einmal während der Bearbeitung durch isotrope Gravur wiederholt wird, um die Spitze(n) der Pyramiden und die zwischen zwei Pyramiden angeordneten Zonen (b) abzurunden.

2. Verfahren nach Anspruch 1, **dadurch gekennzeichnet, dass** der thermisch aktivierte Trockenoxydationsvorgang die Anwendung einer Temperatur über der Raumtemperatur auf der Oberfläche (1a, 1b) des Substrats (1) und die Verwendung eines Oxydationsmittels in gasförmiger Form oder in einem Plasma enthalten umfasst.

3. Verfahren nach Anspruch 2, **dadurch gekennzeichnet, dass** der thermisch aktivierte Trockenoxydationsvorgang die Anwendung einer UV-Strahlung auf der Oberfläche (1a, 1b) des Substrats (1) umfasst.

4. Verfahren nach Anspruch 2, **dadurch gekennzeichnet, dass** der thermisch aktivierte Trockenoxydationsvorgang eine Bearbeitung durch aktiviertes Plasma mit Mikrowellen, Funkfrequenz oder Hyperfrequenz umfasst.

5. Verfahren nach einem der Ansprüche 1 bis 4, **dadurch gekennzeichnet, dass** der Vorgang der Entfernung der dünnen Siliziumoxidschicht (11) auf trockenem Weg erfolgt.

6. Verfahren nach einem der Ansprüche 1 bis 4, **dadurch gekennzeichnet, dass** der Vorgang der Entfernung der dünnen Siliziumoxidschicht (11) auf feuchtem Weg erfolgt.

7. Verfahren nach einem der Ansprüche 1 bis 4, **dadurch gekennzeichnet, dass** der Vorgang der Entfernung der dünnen Siliziumoxidschicht (11) durch Bearbeitung im Reduktionsmedium erfolgt.

8. Verfahren nach einem der Ansprüche 1 bis 7, **dadurch gekennzeichnet, dass** das während der Bearbeitung durch isotrope Gravur gebildete Siliziumoxid eine Gesamtdicke zwischen 10 nm und 500 nm aufweist.

9. Verfahren nach einem der Ansprüche 1 bis 8, **dadurch gekennzeichnet, dass** die Oberfläche (1a, 1b) des Substrats (1), wenn diese durch isotrope Gravur bearbeitet ist, zumindest teilweise mit einem mehrschichtigen Stapel bedeckt wird, nacheinander umfassend:
- eine Passivierungsschicht (2),
- eine dünne Schicht aus amorphem oder mikrokristallinem Silizium (3, 8), die einen vorbestimmten Dotierungstyp aufweist,
- eine Elektrode (4),
- und einen Stromabnehmer (5).

10. Verfahren nach Anspruch 9, **dadurch gekennzeichnet, dass** der Dotierungstyp der dünnen Schicht aus amorphem oder mikrokristallinem Silizium (3) zu dem Dotierungstyp des Substrats aus kristallinem Silizium (1) entgegengesetzt ist.

11. Verfahren nach Anspruch 9, **dadurch gekennzeichnet, dass** der Dotierungstyp der dünnen Schicht aus amorphem oder mikrokristallinem Silizium (8) mit dem Dotierungstyp des Substrats aus kristallinem Silizium (1) identisch ist.

12. Verfahren nach einem der Ansprüche 9 bis 11, **dadurch gekennzeichnet, dass** es einen Schritt des Aufbringens einer Schicht (12a, 12b) umfasst, die mit einem Material einer kristallinen Natur und/oder Struktur und/oder einer unterschiedlichen Morphologie zu jener des Substrats (1) gebildet ist, wobei der Schritt zwischen der anisotropen Gravur der Oberfläche (1a, 1b) und der Bearbeitung durch isotrope Gravur durchgeführt wird, und dass die Schicht während des Vorgangs der Entfernung der dünnen Siliziumoxidschicht (11) entfernt wird.

13. Verfahren nach einem der Ansprüche 9 bis 12, **dadurch gekennzeichnet, dass** die Passivierungsschicht (2) von mindestens einer dünnen Schicht aus intrinsischem amorphem Silizium (2) gebildet ist.

14. Verfahren nach einem der Ansprüche 9 bis 13, **dadurch gekennzeichnet, dass** die Passivierungsschicht (2) von mindestens einer dünnen Schicht aus kristallinem Siliziumoxid in direktem Kontakt mit der Oberfläche (1a, 1b) des Substrats (1) gebildet ist.

## Claims

1. Method for producing at least one photovoltaic cell including the following successive steps:
- anisotropically etching a surface (1a, 1b) of a crystalline silicon substrate (1) configured to pattern the front face (1a) in the form of pyramids;
- and an isotropic etching treatment of said surface (1a, 1b), said treatment including forming a silicon oxide and removing said silicon oxide,
**characterized in that** the isotropic etching treatment of said surface (1) includes two successive operations, respectively consisting in forming by a thermally activated dry oxidation, on said surface (1a, 1b) of the substrate (1), a silicon oxide thin film (11) with a thickness ranging between 2 nm and 500 nm and in removing said silicon oxide thin film (11)
and **in that** the two successive operations constitute an operational cycle repeated at least once during the isotropic etching treatment so as to round off the summits (s) of the pyramids and the zones (b) located between two pyramids.

2. Method according to claim 1, **characterized in that** the thermally activated dry oxidation operation includes the application, to said surface (1a, 1b) of the substrate (1), of a temperature higher than the ambient temperature and the use of an oxidizing agent in a gaseous form or contained in a plasma.

3. Method according to claim 2, **characterized in that** the thermally activated dry oxidation operation includes the application of an ultraviolet radiation to said surface (1a, 1b) of the substrate (1).

4. Method according to claim 2, **characterized in that** the thermally activated dry oxidation operation includes a plasma treatment activated by microwaves, radio-frequencies or ultra high frequencies.

5. Method according to any one of the claims 1 to 4, **characterized in that** the operation of removing said silicon oxide thin film (11) is carried out by a dry method.

6. Method according to any one of the claims 1 to 4, **characterized in that** the operation of removing said silicon oxide thin film (11) is carried out by a wet method.

7. Method according to any one of the claims 1 to 4, **characterized in that** the operation of removing said silicon oxide thin film (11) is carried out by a treatment in a reducing medium.

8. Method according to any one of the claims 1 to 7, **characterized in that** the silicon oxide formed during the isotropic etching treatment has a total thickness comprised between 10 nm and 500nm.

9. Method according to any one of the claims 1 to 8, **characterized in that** the surface (1a, 1b) of the substrate (1), once said surface is treated by isotropic etching, is at least partly covered with a multi-layer stack including successively:
- a passivation layer (2),
- a thin layer of amorphous or microcrystalline silicon (3, 8) with a predetermined doping type,
- an electrode (4)
- and a current collector (5).

10. Method according to claim 9, **characterized in that** the doping type of the thin layer of amorphous or microcrystalline silicon (3) is opposite to the doping type of the crystalline silicon substrate (1).

11. Method according to claim 9, **characterized in that** the doping type of the thin layer of amorphous or microcrystalline silicon (8) is identical to the doping type of the crystalline silicon substrate (1).

12. Method according to any one of the claims 9 to 11, **characterized in that** it comprises a step of depositing a layer (12a, 12b) formed with a material with a nature and/or a crystalline structure and/or a morphology different from that of the substrate (1), said step being carried out between the anisotropic etching of surface (1a, 1b) and the isotropic etching treatment and **in that** said layer is removed during the operation of removing the silicon oxide thin film (11).

13. Method according to any one of the claims 9 to 12, **characterized in that** the passivation layer (2) is formed by at least one thin layer of intrinsic amorphous silicon (2).

14. Method according to any one of the claims 9 to 13, **characterized in that** the passivation layer (2) is formed by at least one thin layer of crystalline silicon oxide in direct contact with said surface (1a, 1b) of the substrate (1).
